# EUROPEAN PATENT SPECIFICATION

(11) **EP 1 184 894 B1**
(45) Date of publication and mention of the grant of the patent: **21.11.2007**
(21) Application number: 00118670.9
(22) Date of filing: 29.08.2000
(51) Int. Cl.: H01L 21/00

(54) **Method of operating a susceptor for semiconductor wafers**
Verfahren zum Betreiben eines Suszeptors für Halbleiterscheiben
Procédé d'opération d'un suscepteur pour des plaquettes semiconductrices

(43) Date of publication of application: 06.03.2002
(73) Proprietor: Qimonda Dresden GmbH & Co. oHG, 01099 Dresden (DE)
(72) Inventor: Storbeck, Olaf, 01099 Dresden (DE)
(74) Representative: Epping - Hermann - Fischer

(56) References cited:
- US-A- 5 580 388
- US-A- 5 872 694
- US-A- 5 893 760
- US-A- 5 958 198
- US-A- 6 025 099

## Description

The invention refers to a method for operating a susceptor that is used to support a semiconductor wafer.

In the field of semiconductor wafer manufacturing typical processing steps comprise CVD (Chemical Vapor Deposition), dry etching, sputtering, PVD (Physical Vapor Deposition), etc. In such processes the wafer is located on a wafer susceptor, a so called wafer chuck. The wafer resides on the chuck with its back side, whereby the front side is subject to the application of reaction gases or physical/chemical treatment by the environment within the process chamber. In any of the above mentioned processes the wafer has to be heated through the chuck.

Semiconductor wafers are usually warped. The warpage is caused by one or multiple layers on the front side of the wafer which cause a tensile strength to the wafer. The wafer is warped either concavely or convexly when seen from its front side. Especially when the wafer is warped concavely, the warpage will be increased when the wafer is placed on a hot chuck in a process chamber. This is due to the fact that the center of the wafer is heated first thereby expanding the center portion of the semiconductor material so that the concave warpage is amplified. This often causes a moving or jumping of the wafer immediately after it is placed on the chuck. Wafer warpage is especially a problem with wafers having a diameter of more than 200 mm (10 inch) and especially with wafer diameters of 300 mm and more.

US patent US 5,872,694 A discloses an electrostatic chuck capable of determining the warpage of a wafer prior to processing the wafer. The susceptor comprises a surface on which the wafer can be placed. A heating means is coupled to the surface for heating the surface. The system including the chuck comprises warpage determining means. The chuck itself has the form of a pedestal that supports the wafer on its back side. The original warpage of the wafer is used to determine the minimum clamping voltage required to clamp the wafer by electrostatic forces to the chuck.

US patent US 6,025,099 A discloses a wafer chuck which is used for projecting images on a photoresist that coats a wafer. The chuck is designed to impress a concave shape to the wafer. A UV lamp of the exposure tool may heat the wafer.

It is an object of the invention to provide a method to support a semiconductor wafer on a susceptor which avoids a movement of the wafer when it is placed on the susceptor.

According to the invention, a method of operating a susceptor for supporting a semiconductor wafer comprises the steps of: providing a susceptor having: a surface for supporting the semiconductor wafer, said surface being concave, said surface having a center and an outer portion surrounding said center, the periphery of said outer portion defining a circle, wherein the distance between said center and a plane defined by said circle is greater than 500 µm, a heater thermally coupled to said surface for heating said surface to a temperature of 400 °C or more; providing a wafer having a diameter of at least 300 mm and having a perimeter edge, wherein said wafer exhibits a warpage; disposing the wafer on said surface, the wafer contacting said surface at the perimeter edge of the wafer only; then heating said surface to a temperature of 400 °C or more, thereby heating the perimeter edge of the wafer first and thus flattening the wafer after expiry of a time period after having placed the wafer on the susceptor, the flat state of the wafer being attained at the latest when thermal equilibrium is established.

The semiconductor wafer is preferably a silicon wafer. With the concave shape of the susceptor surface any movement of the wafer is avoided, especially when the chuck is hot.

According to the concave shape of the surface a plane which is defined by an outer circle of the surface surrounding the center portion of that surface has a distance from the center of the surface. The distance between the circle with the largest diameter and the center is characteristic for the concave shape of the chuck. The distance is larger than 500 µm, being designed for 300 mm wafers. For wafers with a diameter larger than 300 mm the distance can be considerably larger than 500 µm. The characteristic distance between the plane which is defined by the largest circle of the chuck surface and the center of the surface should be such that a wafer having the largest possible warpage touches the surface of the chuck with its circumference. It is to be avoided that the wafer has the first contact with the chuck through its center portion. When touching the hot surface of the chuck with its circumference, the outer portion of the wafer is heated first, so that it extends outwardly and thereby flattens the wafer. Thereby the chuck must be sufficiently concave in form so that each wafer irrespective of its bowing or warpage always touches the chuck at its perimeter first. The above function both applies to wafers which are bowed concavely and wafers which are bowed convexly with respect to the wafer's front side.

For a hot chuck as for the application in process chambers for CVD, dry etch, sputter, and PVD the susceptor is made of metal. Any type of metal suitable for such processes is acceptable. Preferred metals can be aluminum or titanium.

The chuck is coupled to a heating means which can heat the chuck up to at least 400 °C. Any type of known heating method can be applied, e.g. electrical heating or heating by infrared lamps. Since the problem of wafer bowing becomes especially relevant in the semiconductor industry with 300 mm silicon wafers, the invention is applied to the production of wafers having a diameter of at least 300mm.

The surface of the chuck can be structured in any known way. The surface may be smooth or may be provided with concentric, projecting rings. The chuck can be provided with any other type of structure. Also, any type of known means for holding the wafer is acceptable, e.g. provisions for clamping the wafer. Further, holes for the application of a vacuum within the surface of the chuck can be provided at the chuck's surface. When the chuck is structured it is to be noted that the concave shape applies to the envelope curve of the surface.

The invention is now described with reference to the drawings. In the drawings:
- Figure 1: (a) and (b) show a chuck according to the invention with a concave surface before a concave wafer is placed onto the chuck (a) and after reaching thermal equilibrium (b) and
- Figure 2: (a) and (b) show the same chuck for the accomodation of a convexly bowed wafer.

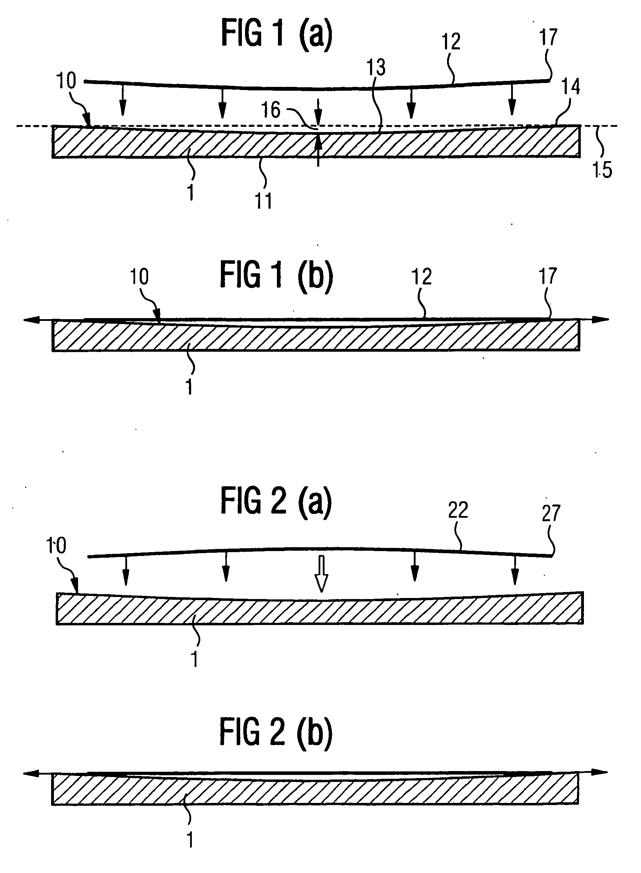

The chuck 1 in figure 1 (a) has an upper surface 10 which is provided to receive a wafer 12. The bottom side 11 of the chuck is shown as a plane surface for simplification purposes. However, there are arbitrary shapes possible for the bottom side 11 of the chuck 1 which can comprise heating means or supporting means to fix the chuck within a process chamber.

The upper surface 10 of the chuck has a concave shape. This means that the outer portion 14 of the chuck is higher than the center portion 13. The chuck 1 has a circular shape. A circle on the surface 10 through the outer portion 14 defines a plane 15. The distance 16 between the plane 15 and the center 13 is characteristic for the concave shape of the surface 10 of the chuck. The wafer 12 to be placed onto the chuck has a diameter of 300 mm in the shown embodiment. The distance 16 for a 300 mm wafer is 500 µm or more. The distance 16 should be larger than the greatest possible bowing of the wafer 12.

As shown in figure 1 (b) the wafer 12 is flattened. This is due to the fact that the perimeter 17 of the wafer touches the surface 10 of the chuck first irrespective of the amount of bowing of the wafer. The chuck is heated to a temperature of 400 °C or more, the perimeter 17 of the wafer 12 is subjected to the heat first. As a result, the outer portion of the silicon material of the wafer 12 is heated first and expands and generates a force pulling outwardly within the silicon material. As a result the wafer 12 is flattened after an appropriate time period when placed onto the chuck. Thereby any jumping of the wafer, which may happen when a 300 mm wafer is placed on a hot chuck with a flat surface, is avoided. The flat state of the wafer is reached latest when thermal equilibrium is established.

In figure 2 the chuck 1 is the same as in figure 1. The wafer 22 to be placed onto the chuck 1 has a convex bowing shape with respect to its front side. The back side of the wafer 22 is placed onto the concave formed surface 10 of the chuck 1. As with the concave shaped wafer 12 of figure 1, the convex shaped wafer 22 of figure 2 also touches the surface 10 of the chuck 1 at its perimeter 27. The hot chuck 1 heats up the outer portion of the wafer 22 first so that an outwardly pulling force within the silicon material of the wafer 22 is generated which flattens the wafer until it is in the equilibrium state.

In any case, the chuck is designed so that the wafer 12, 22 establishes its thermal contact with the surface 10 of the chuck 1 at its perimeter edge. The difference 16 for the chuck 1 is larger than 500 µm for silicon wafers having a diameter of 300 mm.

The chuck 1 has heating means attached to its bottom interface 11 which provide sufficient heat to the chuck. The chuck surface 10 provides a heat of 400°C or slightly more to the wafer 12, 22. The surface 10 of the chuck 1 may have concentric circles which are projecting. Any other suitable microstructure of the surface 10 of the chuck is possible.

## Claims

1. Method of operating a susceptor for supporting a semiconductor wafer comprising the steps of:
providing a susceptor having:
a surface (10) for supporting the semiconductor wafer, said surface being concave;
said surface having a center (13) and an outer portion (14) surrounding said center (13), the periphery of said outer portion (14) defining a circle, wherein the distance between said center (13) and a plane defined by said circle is greater than 500 µm;
a heater thermally coupled to said surface (10) for heating said surface (10) to a temperature of 400 °C or more;
providing a wafer (12) having a diameter of at least 300 mm and having a perimeter edge (17), wherein said wafer exhibits a warpage;
disposing the wafer on said surface (10), the wafer contacting said surface at the perimeter edge (17) of the wafer only;
then heating said surface (10) to a temperature of 400 °C or more, thereby heating the perimeter edge of the wafer first and thus flattening the wafer after expiry of a time period after having placed the wafer on the susceptor, the flat state of the wafer being attained at the latest when thermal equilibrium is established.

2. The method according to claim 1, further comprising the step of providing the susceptor being formed of metal.

3. The method according to claim 1 or 2, further comprising the step of providing said surface (10) of the susceptor being formed with a plurality of concentric, projecting rings, wherein the concave shape of the surface corresponds in this case to the curve enveloping said concentric projecting rings.

## Patentansprüche

1. Verfahren zum Betreiben eines Suszeptors zum Tragen eines Halbleiterwafers, umfassend die folgenden Schritte:
Bereitstellen eines Suszeptors, der folgendes aufweist:
eine Oberfläche (10) zum Tragen des Halbleiterwafers, wobei die Oberfläche konkav ist;
wobei die Oberfläche eine Mitte (13) und einen die Mitte (13) umgebenden Außenabschnitt (14) aufweist, wobei die Peripherie des Außenabschnitts (14) einen Kreis definiert, wobei der Abstand zwischen der Mitte (13) und einer durch den Kreis definierten Ebene größer als 500 µm ist;
eine thermisch an die Oberfläche (10) gekoppelte Heizvorrichtung zum Erhitzen der Oberfläche (10) auf eine Temperatur von 400°C oder mehr;
Bereitstellen eines Wafers (12) mit einem Durchmesser von mindestens 300 mm und einem Umfangsrand (17), wobei der Wafer eine Wölbung aufweist;
Anordnen des Wafers auf der Oberfläche (10), wobei der Wafer die Oberfläche nur am Umfangsrand (17) des Wafers kontaktiert;
dann Erhitzen der Oberfläche (10) auf eine Temperatur von 400°C oder mehr, wodurch der Umfangsrand des Wafers zuerst erhitzt wird und somit der Wafer nach Ablauf einer Zeitperiode geebnet wird, nachdem der Wafer auf dem Suszeptor plaziert worden ist, wobei der flache Zustand des Wafers spätestens dann erzielt wird, wenn ein thermisches Gleichgewicht hergestellt ist.

2. Verfahren nach Anspruch 1, weiterhin umfassend den Schritt des Bereitstellens des aus Metall ausgebildeten Suszeptors.

3. Verfahren nach Anspruch 1 oder 2, weiterhin umfassend den Schritt des Bereitstellens der Oberfläche (10) des Suszeptors, der mit mehreren konzentrischen vorstehenden Ringen ausgebildet ist, wobei die konkave Gestalt der Oberfläche in diesem Fall der die konzentrischen vorstehenden Ringe einhüllenden Kurve entspricht.

## Revendications

1. Procédé pour faire fonctionner un suscepteur afin de supporter une tranche de semiconducteur, comprenant les stades dans lesquels :
on se procure un suscepteur ayant:
une surface (10) pour supporter la tranche de semiconducteur, la surface étant concave ;
la surface ayant un centre (13) et une partie (14) extérieure entourant le centre (13), la périphérie de la partie (14) extérieure définissant un cercle, la distance entre le centre (13) et un plan défini par le cercle étant plus grande que 500 µm ;
un dispositif de chauffage couplé thermiquement à la surface (10) pour chauffer la surface (10) à une température supérieure ou égale à 400°C ;
on se procure une tranche (12) ayant un diamètre d'au moins 300 mm, ayant un bord (17) de périmètre, la tranche ayant un gauchissement ;
on met la tranche sur la surface (10), la tranche étant en contact avec la surface au bord (17) du périmètre de la tranche seulement ;
puis on chauffe la surface (10) à une température supérieure ou égale à 400°C, en chauffant ainsi le bord de périmètre de la tranche d'abord et en aplatissant ainsi la tranche après expiration d'un laps de temps après avoir placé la tranche sur le suscepteur, l'état plat de la tranche étant obtenu au plus tard lorsque l'équilibre thermique est établi.

2. Procédé suivant la revendication 1 comprenant en outre le stade dans lequel le suscepteur que l'on se procure est en métal.

3. Procédé suivant la revendication 1 ou 2, comprenant en outre le stade dans lequel la surface (10) du suscepteur est formé d'une pluralité d'anneaux concentriques en saillie, la forme concave de la surface correspondant dans ce cas à la courbe enveloppant les anneaux concentriques en saillie.
